Europäisches Patentamt

European Patent Office

Office européen des brevets

(11) Veröffentlichungsnummer: **0 421 276 A2**

# (12) EUROPÄISCHE PATENTANMELDUNG

(21) Anmeldenummer: 90118561.1

(22) Anmeldetag: 27.09.90

(51) Int. Cl.5: **C23C 16/46**, C23C 16/26, C23C 16/34

(30) Priorität: 30.09.89 DE 3932828

(43) Veröffentlichungstag der Anmeldung:
10.04.91 Patentblatt 91/15

(84) Benannte Vertragsstaaten:
AT BE CH DE DK ES FR GB GR IT LI LU NL SE

(71) Anmelder: **Nukem GmbH**
**Rodenbacher Chaussee 6**
**W-6450 Hanau 11(DE)**

Anmelder: **SCHUNK OBERFLÄCHENTECHNIK GmbH**
**Rodheimer Strasse 78**
**W-6300 Giessen-Heuchelheim(DE)**

(72) Erfinder: **Hrovat, Milan, Dr.**
**Meisenweg 7**
**W-6458 Rodenbach(DE)**
Erfinder: **Porth, Heinrich**
**Sudetendeutsche Strasse 59**
**W-6450 Hanau 8(DE)**
Erfinder: **Porsch, Gerd, Dr.**
**Am Weinberg 5**
**W-6463 Freigericht 5(DE)**

(54) Verfahren und Vorrichtung zum Beschichten von Formteilen mit kubischem Bornitrid und Diamantkohlenstoff.

(57) Es wird ein Verfahren und eine Vorrichtung zur Beschichtung von Formteilen aus Graphit und metallischen Werkstoffen mit kubischem Bornitrid und Diamantkohlenstoff beschrieben, wobei die Abscheidung mit einem PACVD-Verfahren gleichzeitig auf mehreren Flächen der Formteile erfolgt. Eine notwendige gleichmäßige Temperatur der Formteile erreicht man durch eine Beheizung mit Elektroden im direkten Stromdurchgang.

EP 0 421 276 A2

## VERFAHREN UND VORRICHTUNG ZUM BESCHICHTEN VON FORMTEILEN MIT KUBISCHEM BORNITRID UND DIAMANTKOHLENSTOFF

Die Erfindung betrifft ein Verfahren und eine Vorrichtung zum Beschichten von Formteilen aus Graphit und metallischen Werkstoffen gleichzeitig auf zwei oder mehreren Flächen mit kubischem Bornitrid oder Diamantkohlenstoff mittels eines PACVD (plasmaunterstützte chemische Gasphasenabscheidung) -Verfahrens unter Erhitzen der Formteile auf 700 bis 1500 K.

Die Beschichtung von Formteilen (Substraten) mit Hartstoffschichten, wie z.B. Siliciumkarbid, Siliciumnitrid, Titannitrid und Wolframkarbid, nimmt ständig an Bedeutung zu. Die Abscheidung dieser Schichten erfolgt mittels CVD- bzw. PACVD-Verfahren (chemical vapour deposition bzw. plasma assisted chemical vapour deposition) und wird im großtechnischen Maßstab beherrscht. Darüberhinaus werden seit Mitte der achziger Jahre erhebliche Anstrengungen unternommen, die hervorragenden Eigenschaften von kubischem Bornitrid und von Diamantkohlenstoff in Form dünner Schichten ebenfalls nutzbar zu machen.

Bornitrid weist insgesamt zwei hexagonale (Graphit-bzw. Wurzitstruktur) und eine kubische Kristallstruktur auf. Kubisches Bornitrid ist den beiden hexagonalen Strukturen überlegen und zeichnet sich durch hohe Dichte, hohe chemische Stabilität, hohe Verschleißfestigkeit, gute Wärmeleitfähigkeit und hervorragende Beständigkeit gegenüber vielen Metallschmelzen aus. Kubisches Bornitrid ist hinter Diamant der zweithärteste Werkstoff. Die Abscheidung von Schichten mit hohem Anteil an der kubischen Struktur erwies sich als sehr schwierig, insbesondere dann, wenn dreidimensionale Substrate, d.h. zwei oder mehrere Flächen gleichzeitig zu beschichten sind, wie zum Beispiel Tiegel, Hohlzylinder oder Gleitringe.

Dünne Diamantkohlenstoffschichten zeichnen sich ebenfalls durch hervorragende Eigenschaften aus, die denen des kubsichen Bornitrids in vielen Fällen überlegen sind. Die Diamantschichten besitzen gegenüber dem kubischen Bornitrid eine höhere Härte, höheren Verschleißwiderstand, höhere Wärmeleitfähigkeit, hohe Transparenz in weitem Spektralbereich, sehr gute Strahlungsbeständigkeit und besonders vorteilhafte elektronische Eigenschaften. Die Herstellung von dünnen Diamantschichten auf dreidimensionale Substrate stellt ebenfalls ein großes technisches Problem dar.

Grundprinzip aller PACVD-Verfahren ist die Erzeugung eines Plasmas durch Zersetzung und Aktivierung bzw. Ionisation der Moleküle und Atome eines geeigneten Gasgemisches. Um die Bedingungen zu schaffen, kubisches Bornitrid oder Diamantkohlenstoff abzuscheiden, muß das Plasma eine möglichst hohe Ionendichte und Ionenenergie aufweisen. Eine ganz entscheidende Größe ist auch eine möglichst gleichmäßige Substrattemperatur, die oberhalb 700 K, vorzugsweise bei 1300 K liegen muß.

Beim Beschichten mit Bornitrid und Diamantkohlenstoff sind Substattemperaturen von mehr als 700 K erforderlich. Um die erforderliche Schichtqualität sicherzustellen, ist eine gleichmäßige Temperaturverteilung im Substrat notwendig. Bei dreidimensionalen Substraten, wie z.B. Tiegel oder Hohlzylinder, erwies sich eine gleichmäßige Temperaturführung oberhalt 700 K mit den bekannten Heizvorrichtungen äußerst schwierig. Bei der Ankopplung der Wärme an das zu beschichtende Teil oder beim Erhitzen mit Heizstrahlern treten unvermeidlich hohe Temperaturgradienten auf, die bereits bei relativ kleinen Abmessungen von etwa 100 mm Tiegelhöhe zu einem Temperaturgefälle von mehreren 100 K führen können und somit bei der Beschichtung die unerwünschte Bildung von amorphen Phasen bzw. hexagonalen Strukturen zur Folge haben.

Es war daher Aufgabe der vorliegenden Erfindung, ein Verfahren zum Beschichten von Formteilen aus Graphit und metallischen Werkstoffen gleichzeitig auf zwei oder mehreren Flächen mit kubischem Bornitrid oder Diamentkohlenstoff mittels einer PACVD-Abscheidung unter Erhitzen der Formteile auf 700 bis 1500 K zu entwickeln, bei dem die dreidimensionalen Formteile auf eine möglichst gleichmäßige Temperatur innerhalb jedes Teils gebracht werden können. Außerdem sollte eine entsprechende Vorrichtung entwickelt werden.

Diese Aufgabe wird erfindungsgemäß dadurch gelöst, daß die Formteile mit Hilfe von Elektroden im direkten Stromdurchgang erhitzt werden, wobei die an den Abschlußstellen zwischen Elektroden und Elektrodenbefestigung abgeführte Wärme im Gleichgewicht stehen muß mit der in den Elektroden erzeugten Wärme.

Überraschenderweise erzielt man mit dieser Beheizungsart eine sehr gleichmäßige Temperaturverteilung in den Formteilen.

Eine Vorrichtung zur Beschichtung von dreidimensionalen Formteilen gleichzeitig auf zwei oder mehreren Flächen besteht aus einem Gehäuse mit den an sich bekannten Elementen zur Erzeugung eines Vakuums, des Plasmas, aus den Beschichtungsgasen und der Beheizung der Formteile. Diese Beheizung besteht erfindungsgemäß aus zwei Elektroden, zwischen denen das jeweiligen Formteil befestigt ist.

Dabei muß der Werkstoff in bezug auf spezifischen elektrischen Widerstand und spezifische Wärmeleitfähigkeit und die Konstruktion der Elektroden in bezug auf ihre Wärmeleitfähigkeit so auf das jeweilige Formteil abgestimmt sein, daß an den Kontaktflächen nur ein vernachlässigbarer Wärmestrom vom Formteil zur Elektrode oder umgekehrt fließt, sodaß sich im Formteil ein Temperaturgradient von höchstens 50 K einstellt.

Vorzugsweise bestehen die Elektroden jeweils aus einem dem Querschnitt des Formteils angepassten, auf dem Formteil aufsitzenden, runden oder vieleckigen Ring, der über zwei oder mehrere Stege mit einer dem Stromanschluß dienenden Scheibe verbunden ist.

Bei der Dimensionierung der Elektroden sind der spezifische elektrische Widerstand und die Wärmeleitfähigkeit des Werkstoffs zu berücksichtigen. Als Werkstoff für die Elektroden hat sich Wolfram besonders gut bewährt. Wolfram zeichnet sich durch eine günstige Wärmeleitfähigkeit und einen günstigen spezifischen elektrischen Widerstand bei einer Temperatur von 1000 K aus. Eine Rekristallisierung kann durch geringe Zusätze an Schwermetalloxiden unterbunden werden. Außerdem ist Wolfram im erforderlichen Temperaturbereich mechanisch hoch belastbar.

Als günstig hat es sich erwiesen, wenn bei Wolframelektroden das Verhältnis der Gesamtquerschnittsfläche der Stege zur Höhe der Stege im Bereich zwichen 1,5 und 3 liegt.

Bei der Beschichtung von Tiegeln aus Graphit mit kubischem Bornitrid hat sich eine Substrattemperatur von 1100 K besonders gut bewährt. Bei Tiegelabmessungen vom Außendurchmesser 100 mm und Höhe 100 mm lag das Temperaturgefälle mit 30 K äußerst niedrig.

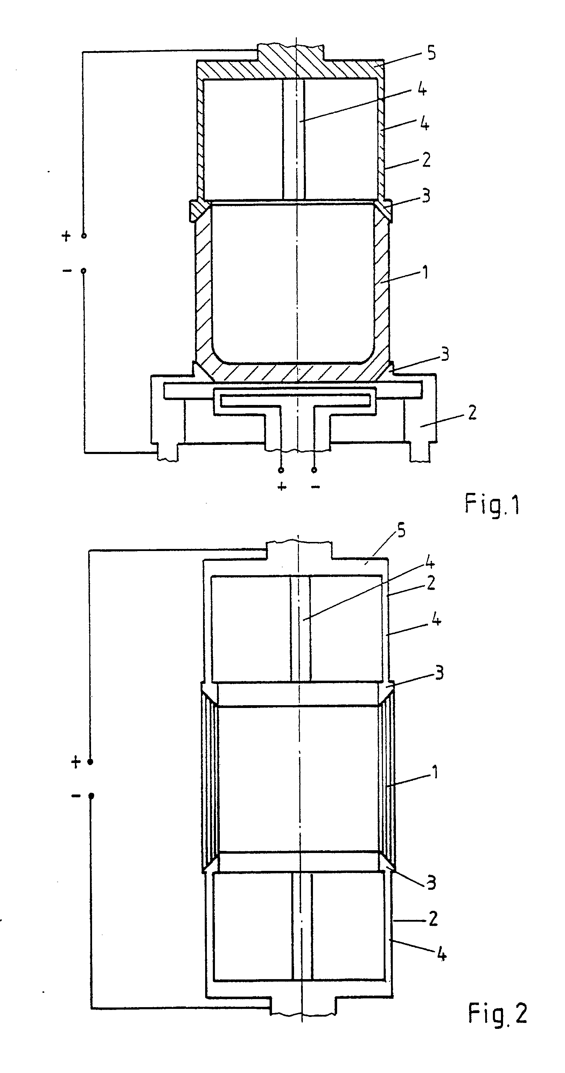

Di Abbildungen 1 und 2 zeigen schematisch im Längsschnitt die Heizelektroden mit den dazwischen befestigten Formteilen, in Abbildung 1 einen Tiegel und in Abbildung 2 einen Hohlzylinder. Das Formteil (1) befindet sich zwischen zwei Elektroden (2), die jeweils gleich oder verschieden aufgebaut sein können, je nach Art und Dimensionierung des Formteils (1). Im Fall eines zu beschichtenden Tiegels oder eines Hohlzylinders bestehen die Elektroden (2) aus einem dem Formteil (1) angepaßten Ring (3), der über Stege (4) mit einer dem Stromanschluß dienenden Scheibe (5) verbunden ist.

Folgende Beispiele sollen das erfindungsgemäße Verfahren verdeutlichen:

1. Beschichtung eines Graphittiegels mit kubischem Bornitrid.

Der Graphittiegel mit Außendurchmesser 100, Innendurchmesser 90 und Höhe 100 mm wurde aus einem Graphit mit folgenden Eigenschaften ausgearbeitet:
- Dichte 1,7 g/cm$^3$
- Druckfestigkeit 82 N/mm$^2$
- E-Modul 10 x 10$^3$ N/mm$^2$
- spez. elektr. Widerstand 12,5 Ω mm$^2$/m

Vor dem Beschichten wurde der Tiegel im Vakuum bei 2400 K ausgeglüht. Anschließend wurde der Tiegel in einem Mikrowellen-Multipolar-Plasma-DECR-Reaktor eingesetzt und beschichtet. Die zwei Elektroden aus Wolfram bestanden jeweils aus einem Ring (110 mm ⌀, Stärke 10 mm) mit 3 Stegen (100 mm Höhe und 10 mm Stegdurchmesser). Bei einem Spannungsabfall von 1,7 V betrug die Stromstärke 1700 A, was einer Gesamtleistung von 2,9 kW entsprach. Eine zusätzliche Heizung sorgte für die Konstanthaltung der Temperatur des Tiegelbodens. Unter diesen Bedingungen stellte sich über die Tiegellänge eine Temperatur von 1100 K ± 30 K ein. Als Reaktionsgase dienten Diboran $B_2H_6$ und Ammoniak $NH_3$, als Trägergas Wasserstoff $H_2$.

Die Beschichtung erfolgte bei einem Unterdruck von 3 x 10$^{-3}$ mbar. Das Verhältnis von $NH_3$ zu $B_2H_6$ betrug 2,5 : 1, die Aufwachsrate lag mit 1,7 nm/s relativ hoch. Die Beschichtung dauerte 5 Stunden. Die metallographischen Untersuchungen ergaben Schichtdickenwerte im Bereich von 12 - 45 μm. Der ermittelte Anteil an kubischem Bornitrid nach Röntgenfeinstuckturanalyse lag oberhalb 60 %.

2. Beschichtung eines Hohlzylinders aus Graphit mit Diamentkohlenstoff.

Analog dem Beispiel 1 wurde aus dem gleichen Graphit ein Hohlzylinder mit Abmessungen : Außendurchmesser 100 mm, Innendurchmesser 90 mm und Höhe 100 mm angefertigt. Zunächst wurde der Hohlzylinder nach dem üblichen CVD-Verfahren bei einer Temperatur von 1780 K mit einer ca. 30 um-dicken SiC-Schicht beschichtet. Die SiC-Beschichtung erfolgte im Normaldruck, dabei dienten Methyltrichlorsilan als Reaktions- und Wasserstoff als Trägergas. Die hochdichte SiC-Schicht hatte eine Dichte von 3,2 g/cm$^3$, die Vickershärte betrug 34,8 GN/m$^2$. Mit der Röntgenfeinstrukturanalyse wurde kubisches β-SiC nachgewiesen. Vor dem Einsetzen in den Mikrowellen-Multipolar-Plasma-DECR-Reaktor wurde der Hohlzylinder bei 1700 K im Vakuum ausgeglüht.

Der Einbau des Hohlzylinders zwischen den beiden Wolframelektroden erfolgte analog dem Beispiel 1 (s. Abb. 2). Die Substrattemperatur betrug 1300 K, was einer Gesamtleistung von 4,2 kW entsprach. Als Prozeßgas dienten Methan ($CH_4$) verdünnt mit Wasserstoff ($H_2$). Die Methankonzen-

tration im Wasserstoff betrug 0,8 Molprozent. Die Abscheiderate 0,3 nm/s . Nach 5 Stunden wurde die Beschichtung abgeschlossen. Die metallographischen Untersuchungen und die REM-Aufnahmen ergaben Schichtdicken im Bereich von 2 und 8 μm. Die Diamantkristallite wurden mit Röntgenfeinstrukturanalyse nachgewiesen.

## Ansprüche

1. Verfahren zum Beschichten von Formteilen aus Graphit und metallischen Werkstoffen gleichzeitig auf zwei oder mehreren Flächen mit kubischem Bornitrid oder Diamantkohlenstoff mittels eines PACVD-(plasmaunterstützte chemische Gasphasenabscheidung) -Verfahrens unter Erhitzen der Formteile auf 700 bis 1500 K,
dadurch gekennzeichnet,
daß die Formteile mit Hilfe von Elektroden im direkten Stromdurchgang erhitzt werden, wobei die an den Anschlußstellen zwischen Elektroden und Elektrodenbefestigungen abgeführte Wärme im Gleichgewicht stehen muß mit der in den Elektroden erzeugten Wärme.

2. Vorrichtung zur Beschichtung von Formteilen nach Anspruch 1, bestehend aus einem Gehäuse mit Elementen zur Erzeugung eines Vakuums, eines Plasmas, aus den Beschichtungsgasen und der Beheizung der Formteile,
dadurch gekennzeichnet,
daß die Beheizungselemente aus zwei Elektroden (2) bestehen, zwischen denen das jeweilige Formteil (1) befestigt ist, wobei der Elektrodenwerkstoff in bezug auf spezifischen elektrischen Widerstand und spezifische Wärmeleitfähigkeit und die Konstruktion der Elektroden (2) in bezug auf ihre Wärmeleitfähigkeit so auf das jeweilige Formteil abgestimmt sein müssen, daß an den Kontaktflächen nur ein vernachlässigbarer Wärmestrom vom Formteil (1) zur Elektrode (2) oder umgekehrt fließt.

3. Vorrichtung nach Anspruch 2,
dadurch gekennzeichnet,
daß die Elektroden (2) jeweils aus einem dem Querschnitt des Formteils (1) angepassten, auf dem Formteil (1) aufsitzenden, runden oder vielekkigen Ring (3) bestehen, die über zwei oder mehrere Stege (4) mit einer dem Stromanschluß dienenden Scheibe (5) verbunden sind.

4. Vorrichtung nach Anspruch 2 und 3,
dadurch gekennzeichnet,
daß die Elektroden (2) aus Wolfram bestehen.

5. Vorrichtung nach Anspruch 2 bis 4,
dadurch gekennzeichnet,
daß der Quotient der Gesamtquerschnittsfläche der Stege (4) zur Höhe der Stege (4) im Bereich zwischen 1,5 und 3 mm liegt.

Fig.1

Fig.2